# EUROPÄISCHE PATENTSCHRIFT

(11) **EP 1 714 321 B1**
(45) Veröffentlichungstag und Bekanntmachung des Hinweises auf die Patenterteilung: **12.05.2010**
(21) Anmeldenummer: 05707380.1
(22) Anmeldetag: 14.02.2005
(51) Int. Cl.: H01L 27/02

(54) **Schaltungsanordnung und Verfahren zum Schutz einer integrierten Halbleiterschaltung**
Circuit arrangement and method for protecting an integrated semiconductor circuit
Montage et procédé pour protéger un circuit intégré à semi-conducteur

(30) Priorität: 13.02.2004 DE 102004007241; 22.11.2004 DE 102004056222
(43) Veröffentlichungstag der Anmeldung: 25.10.2006
(73) Patentinhaber: austriamicrosystems AG, 8141 Unterpremstätten (AT)
(72) Erfinder: DEUTSCHMANN, Bernd, A-8010 Graz (AT); FANKHAUSER, Bernd, A-8010 Graz (AT); MAYERHOFER, Michael, A-8010 Graz (AT); CHOJECKI, Pawel, A-8010 Graz (AT)
(74) Vertreter: Epping, Wilhelm
(86) Internationale Anmeldenummer: PCT/EP2005/001476
(87) Internationale Veröffentlichungsnummer: WO 2005/078798

(56) Entgegenhaltungen:
- EP-A- 0 822 596
- US-A- 5 982 601
- US-B1- 6 618 233

## Beschreibung

Die Erfindung betrifft eine Schaltungsanordnung zum Schutz einer integrierten Halbleiterschaltung mit einer Schutzschaltung, die eine Thyristorstruktur enthält und zwischen ein zu schützendes Element und ein Bezugspotential geschaltet ist, und mit einer Steuerschaltung für die Ansteuerung der Schutzschaltung sowie ein entsprechendes Verfahren zum Schutz einer integrierten Halbleiterschaltung.

Integrierte Halbleiterschaltungen (ICs) können durch transiente Pulse oder Überspannungen, die über Anschlüsse (Pads) oder direkt in Leitungen eingekoppelt werden, so beschädigt werden, dass sie funktionsunfähig oder gar zerstört werden. Derartige Pulse oder Überspannungen können beispielsweise bei sogenannten elektrostatischen Entladungen (englisch: ESD, Electrostatic Discharge) auftreten. Hohe Spannungen und hohe Ströme, verbunden mit transienten bzw. ESD-Störungen, bewirken das Auftreten hoher störender Leistungen.

Auch in vielen Anwendungsgebieten, z.B. der Automobiltechnik, kann ein derartiger Puls (z.B. Burst) auftreten. In der Automobiltechnik beispielsweise besteht das Erfordernis, derartige Schaltungen, die im Hochvoltbereich bis 90 Volt oder darüber funktionieren müssen, auch für deutlich höhere Störpuls-Pegel auszulegen.

Für Hochvoltanwendungen, die mit Hochvoltprozessen hergestellt sind, werden gewöhnlich Schutzeinrichtungen vorgesehen, die von einem elektrischen Durchbruch ausgelöst bzw. getriggert werden. Die Durchbruchspannungen müssen deutlich oberhalb der maximal zulässigen Betriebsspannungen der zu schützenden Anwendungsschaltung liegen. Nur dann kann eine ungestörte Funktionalität der integrierten Schaltung garantiert werden. Im Fehlerfall, z.B. bei Vorliegen einer unzulässig hohen Spannung, wird diese Überspannung durch die Schutzschaltung gegen Bezugspotential bzw. Masse abgeleitet und so nachfolgende Baugruppen vor der hohen Spannung geschützt.

Eine Alternative für solche durchbruch-basierten Schutzkonzepte ist eine aktive Schaltung zum Schutz einer integrierten Schaltung, bestehend aus einer Kombination einer aktiven Triggerschaltung mit einer bekannten Schutzeinrichtung wie einem Thyristor bzw. einem bipolaren oder MOS-Schutztransistor.

Aktive Schaltungen zum Schutz des ICs werden oft durch den Anstieg des transienten Signals getriggert. Dabei wird der Signalanstieg pro Zeiteinheit detektiert und über eine Ansteuerschaltung ein Schutztransistor oder eine Schutzschaltung durchgeschaltet.

Im Fehlerfall kann die Schutzschaltung demnach als aktiv getriggerter Überspannungs- oder Überstromableiter verstanden werden. Im Fehlerfall ist eine schnelle Durchsteuerung der Schutzschaltung notwendig.

Geringe Einschaltzeiten und eine präzise Einschaltschwelle der Schutzschaltung für den integrierten Schaltkreis sowie deren Schutzwirkung bei unterschiedlichen Formen von Störpulsen sind bedeutende Aspekte der Produktspezifikation und stellen einen Wettbewerbsvorteil dar.

Aus der US 5,982,601 ist ein Thyristor (SCR - Silicon Controlled Rectifier) für den ESD-Schutz bekannt, der direkt durch das transiente Signal getriggert wird. Der Thyristor ist in der Halbleiteranordnung in an sich bekannter Weise mittels einer n-Wanne, einer p-Wanne und hoch dotierten n- und p-Gebieten realisiert. Die transiente Spannung wird mit einem RC-Glied erfasst. Mit nachgeschalteten Invertern wird der an der Kapazität detektierte Spannungspegel in ein Steuersignal umgeformt, das die Basis des pnp-Transistors der Thyristorstruktur ansteuert. Sobald der Ausgangsstrom des nun aktiven pnp-Transistors an einem Widerstand einen ausreichend großen Spannungsabfall erzeugt, schaltet der npn-Transistor der Thyristorstruktur durch, so dass der transiente Puls durch die niederohmige Thyristorstrecke vom Padpotential des I/O-Pins gegen Bezugspotential abgeleitet wird. Der Thyristor bleibt danach selbsttätig durchgeschaltet, bis sein Strom den Haltestrom unterschreitet und die Löschbedingung erfüllt ist.

Ein weiteres Dokument XP-002346581, IEEE TRANSACTIONS ON DEVICE AND MATERIALS RELIABILITY, VOL 3, NO 3, SEPTEMBER 2003: SCC DEVICE WITH DOUBLE TRIGGERED TECHNIQUE FOR ON-CHIP ESD PROTECTION IN SUB QUARTER MICRON SLICIDED CMOS PROCESSES, ist bekannt.

Der Erfindung liegt die Aufgabe zugrunde, eine Schaltungsanordnung und ein Verfahren zum Schutz von integrierten Halbleiterschaltungen anzugeben, die ein verbessertes Verhalten ermöglichen. Weiterhin sollen eine Schaltungsanordnung und ein Verfahren angegeben werden, die insbesondere auch für Hochvoltprozesse bzw. für Hochvoltanwendungen geeignet sind.

Diese Aufgabe löst die Erfindung mit den Merkmalen des Patentanspruchs 1.

Die Erfindung hat den Vorteil, dass die Schaltungsanordnung als aktiv getriggerte Schutzschaltung und das entsprechende Verfahren ein schnelles Durchschalten der Thyristorstruktur ermöglichen. Ferner lässt sich die Erfindung in Hochvoltanwendungen, die unter Verwendung von Hochvoltprozessen hergestellt sind, integrieren.

Vorteilhafte Ausgestaltungen und Weiterbildungen der Erfindung sind Gegenstand der abhängigen Patentansprüche.

Die Erfindung wird im folgenden anhand von Ausführungsbeispielen im Zusammenhang mit den Figuren näher erläutert. Gleiche oder gleichwirkende Elemente sind in den Figuren mit gleichen Bezugszeichen versehen.

Es zeigen:
- Figur 1: eine schematisch dargestellte Schaltungsanordnung mit Schutzschaltung und Steuer- bzw. Triggerschaltung
- Figur 2: eine zweite schematisch dargestellte Schaltungsanordnung mit Schutzschaltung und Triggerschaltung,
- Figur 3: eine dritte schematisch dargestellte Schaltungsanordnung mit Schutzschaltung und Triggerschaltung,
- Figur 4: eine vierte schematisch dargestellte Schaltungsanordnung mit Schutzschaltung und Triggerschaltung,
- Figur 5: eine weitere schematisch dargestellte Schaltungsanordnung mit Schutzschaltung und Triggerschaltung und
- Figur 6: einen schematischen Querschnitt einer Struktur zur Realisierung des Thyristors in einem Hochvoltprozess.

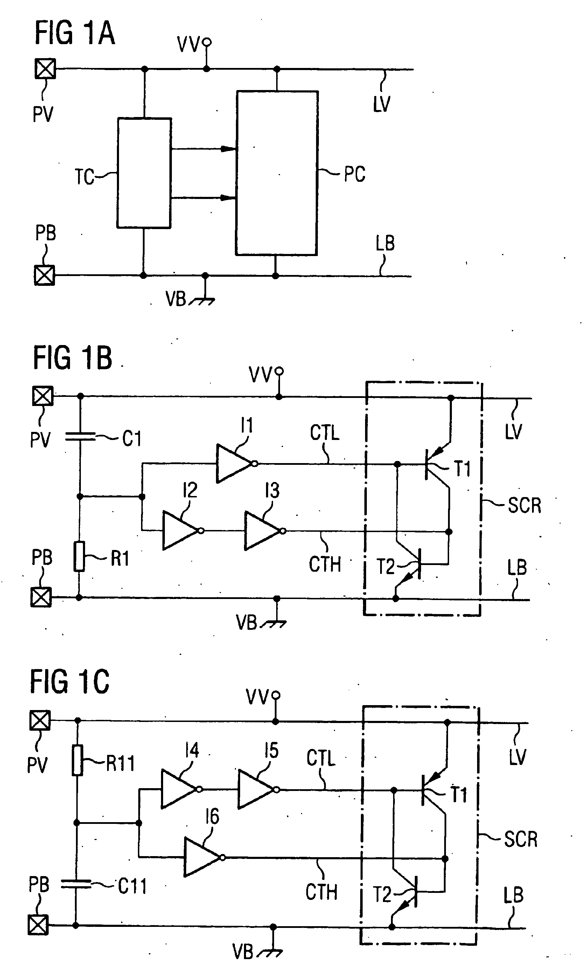

In Figur 1 ist die Erfindung prinzipiell und anhand von zwei Ausführungsbeispielen näher erläutert. Gemäß Figur 1a ist ein Anschluss PV mit einer Leitung LV verbunden, die auf einem Potential VV liegt. Das Potential VV kann z.B. das positive Versorgungspotential VDD oder das Potential eines Eingangs-/Ausgangs-Anschlusses (I/O Pad) sein. Der Anschluss PV bzw. die Leitung LV sind gegen transiente Pulse bzw. gegen Überspannung zu schützen. Diese Überspannung muss gegen ein Bezugspotential VB abgeleitet werden, das beispielsweise das Massepotential sein kann. Die das Bezugspotential VB führende Leitung LB ist mit dem Anschluss PB verbunden.

Die eigentliche Aufgabe der Ableitung von Störpulsen bzw. Überspannungen erfüllt die Schutzschaltung PC, die in allen Ausführungsbeispielen als SCR bezeichnet ist. Gesteuert bzw. getriggert wird die Schutzschaltung PC bzw. SCR von einer Steuerschaltung TC, die eingangsseitig mit den Anschlüssen PV und PB verbunden ist. Die Steuerschaltung TC enthält eine Detektorschaltung, die in der Lage ist, die an dem Anschluss PV bzw. der Leitung auftretenden transienten Pulse zu erkennen und Steuersignale für die Schutzschaltung PC bzw. SCR zu erzeugen.

Die Steuerschaltung TC erzeugt mehrere Steuersignale, die jeweils ein aktives Element der Schutzschaltung PC bzw. SCR ansteuern. In Figur 1 sind dies die Signale CTL bzw. CTH, die die Transistoren T1 bzw. T2 ansteuern. Allgemein sind die aktiven Elemente der Schutzschaltung PC bzw. SCR so verschaltet, dass sie bei einer Ansteuerung durch die Steuersignale der Trigger- bzw. Steuerschaltung TC eine niederohmige Verbindung zwischen der Leitung LV bzw. dem Anschluss PV und dem Bezugspotential VB herstellen. Die Schutzschaltung PC bzw. SCR kann dabei auch höhere Ströme gegen Bezugspotential VB ableiten.

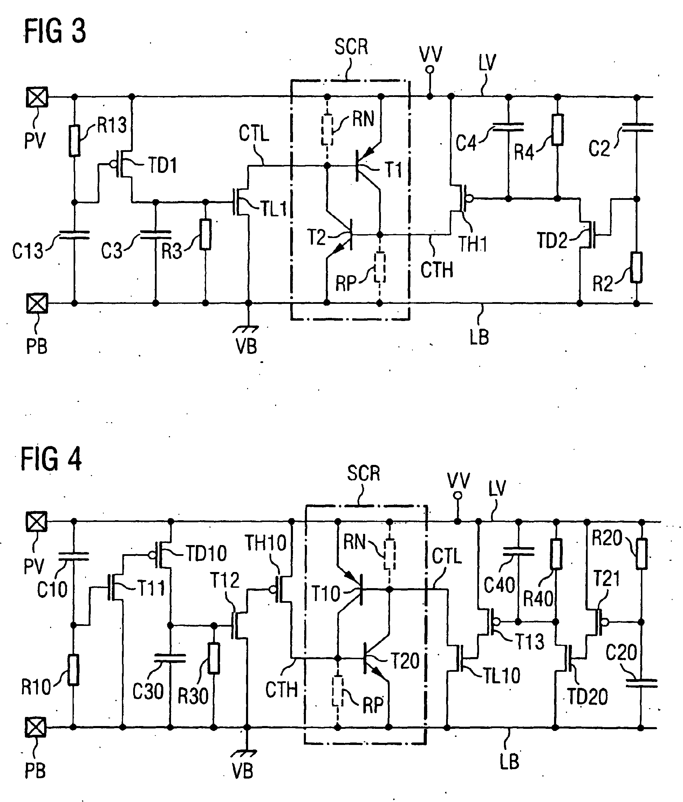

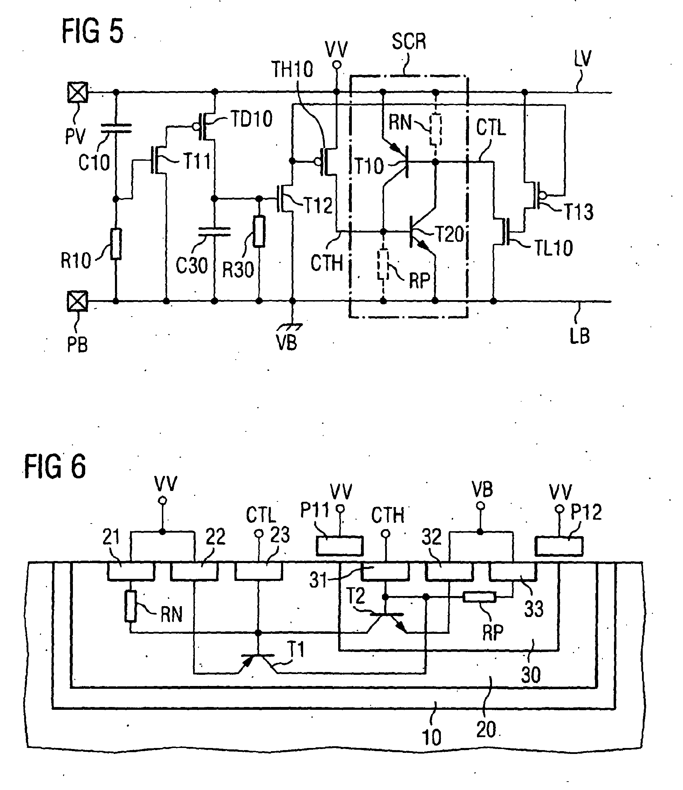

Im typischen Anwendungsfall der Figur 1 enthält die Schutzschaltung PC bzw. SCR eine Thyristorstruktur. Ein Thyristor ist ein Vierschichtbauelement, das im Ersatzschaltbild als zwei miteinander verschaltete Bipolar-Transistoren dargestellt wird. Die Steuerschaltung TC steuert im Fehlerfall die beiden Transistoren T1 und T2 (T10 und T20 in Fig. 4 bzw. Fig. 5) der Thyristorstruktur der Schutzschaltung mit zwei Steuersignalen aktiv an. Dazu werden direkt in die beiden Basis-Emitter-Übergänge Ströme injiziert.

Das Durchschalten der Schutzschaltung PC bzw. SCR mittels Steuersignalen für die aktiven Elemente der Schutzschaltung, die in ihrer Zusammenschaltung die niederohmige Verbindung zwischen der Leitung LV und der Leitung LB herstellen müssen, wird so gezielt eingeleitet. Dadurch ist es möglich, die Schutzschaltung PC bzw. SCR präzise und schnell in den durchgeschalteten Zustand zu führen. Dies führt zu einem verbesserten Ansprechverhalten der Schutzschaltung und damit zu einem besseren Schutz der integrierten Halbleiterschaltung, die in der Figur 1 symbolisch anhand der Anschlüsse PB und PV und den damit verbundenen Leitungen dargestellt ist.

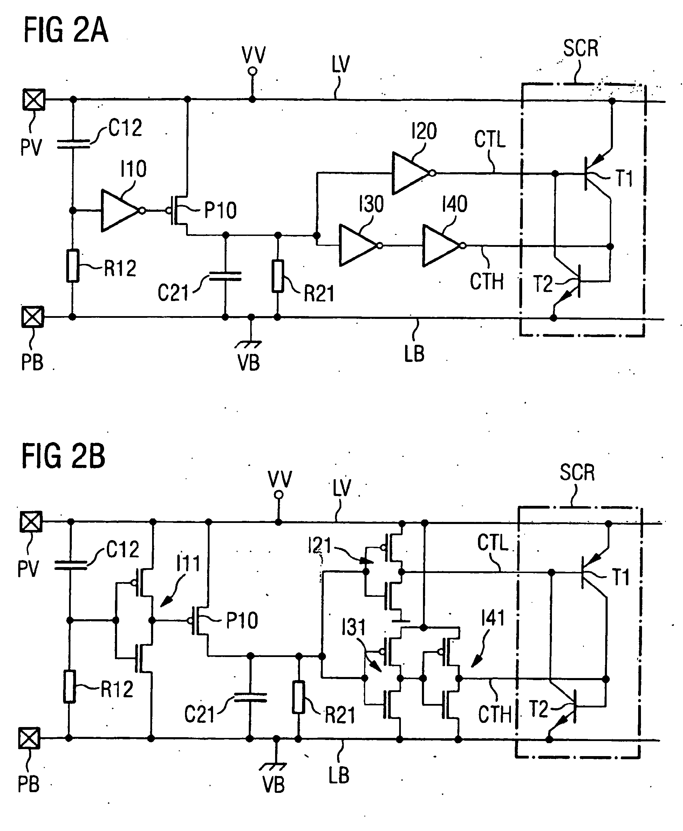

Gemäß Figur 1b) ist ein erstes konkretes Beispiel dargestellt. Die Schutzschaltung ist als Thyristor SCR mit den beiden Transistoren T1 und T2 ausgeführt. T1 ist ein pnp-Transistor, der mit seinem Emitter an der Spannung führenden Leitung LV angeschlossen ist, während T2 ein npn- Transistor ist, der emitterseitig an dem Bezugspotential VB angeschlossen ist. Die Kollektoren der beiden Transistoren sind kreuzweise mit der Basis des jeweils anderen Transistors verschaltet. Bei einer integrierten Schaltung kann eine derartige Transistorstruktur in an sich bekannter Weise durch eine n- bzw. p-Wanne mit Wannenwiderständen RN bzw. RP und entsprechend darin angeordneten hoch dotierten Bereichen realisiert werden, siehe Figur 6 bzw. schematisch die Figuren 3 bis 5. In den Figuren 1 und 2 sind die Widerstände Rn bzw. RP zum besseren Verständnis der Funktionsweise nicht eingezeichnet.

Die Steuerschaltung ist in der Figur 1b) durch eine Detektorschaltung mit nachgeschalteten Invertern realisiert. Die Detektorschaltung ist als RC-Glied aus der Serienschaltung einer Kapazität C1 und eines Widerstands R1 ausgeführt, die mit den Leitungen LV bzw. LB und den entsprechenden Anschlüssen PV und PB verbunden ist.. Dem Verbindungsknoten der Kapazität C1 und des Widerstandes R1 sind Inverter nachgeschaltet, die ausgangsseitig jeweils die Basen der Transistoren T1 und T2 ansteuern. Dabei ist der Inverter I1 mit der Basis des Transistors T1 verbunden und zwei in Serie geschaltete Inverter I2 und I3 mit der Basis des Transistors T2. Die Inverter sind notwendig, um das am Verbindungspunkt der Kapazität C1 und des Widerstands R1 anliegende Potential in definierte.Steuersignale CTL und CTH umzuwandeln, die die Transistorelemente des Thyristors SCR ansteuern.

Die Detektorschaltung aus Kapazität C1 und Widerstand R1 bildet als RC-Glied einen komplexen Spannungsteiler, an dessen Mittelabgriff der Spannungsanstieg des Störpulses erfasst wird. Im Fehlerfall eines transienten Pulses wird die Kapazität C1 niederohmig, sodass sich am Ausgangspunkt der Detektorschaltung ein hohes Potential einstellt. Sobald die Spannung die Schaltschwelle des Inverters I1 erreicht, schaltet dessen Ausgangssignal CTL auf niedriges Potential, so dass der pn-Übergang zwischen Emitter und Basis von T1 die Schaltschwelle überschreitet und T1 durchschaltet.

Andererseits liegen parallel zu I1 die hintereinander geschalteten Inverter I2 und I3, die das am Abgriffsknoten der Detektorschaltung detektierte Spannungssignal in ein definiertes Steuersignal CTH zur Ansteuerung des npn-Transistors T2 umsetzen. Somit schaltet T2 nahezu zeitgleich mit T1 in den leitenden Zustand über. Damit wird der Thyristor SCR leitend und der auf der Leitung LV bzw. dem Anschluss PV anliegende transiente Puls kann gegen Bezugspotential abgeleitet werden.

Das Beispiel gemäß Figur 1c) unterscheidet sich vom Beispiel nach Figur 1b) dadurch, dass die Detektorschaltung aus dem kapazitiven und dem resistiven Bauelement in umgedrehter Richtung mit den Anschlüssen PV und PB verbunden ist. Dabei liegt der Widerstand R11 am Anschluss PV und die Kapazität C11 am Anschluss PB. Somit drehen sich die Spannungsverhältnisse am Ausgang der Detektorschaltung, nämlich dem Verbindungspunkt von R11 und C11 um, so dass auch die Ansteuerung der Transistor T1 und T2 anders erfolgen muss. So ist dem Ausgang der Detektorschaltung die Serienschaltung aus den Invertern I4 und I5 nachgeschaltet, um den Transistor T1 anzusteuern. Parallel zu diesen Invertern ist dem Ausgang der Detektorschaltung der Inverter I6 nachgeschaltet, der den Transistor T2 ansteuert.

Im Fehlerfall eines transienten Pulses wird die Kapazität C11 niederohmig, so dass sich am Ausgangspunkt der Detektorschaltung ein niedriges Potential einstellt. Der Inverter I6 setzt dieses niedrige Potential in eine zur Durchsteuerung des Transistors T2 erforderliche Spannung bzw. einen entsprechenden Steuerstrom um. Andererseits formen die in Serie geschalteten Inverter I4 und 15 die Ausgangsspannung an der Kapazität C11 in ein Steuersignal niedrigen Potentials bzw. einen entsprechenden Strom um, so dass der Transistor T1 durchschaltet.

Die Detektorschaltung ist in den Beispielen der Figur 1 als RC-Glied ausgeführt, jedoch darauf nicht beschränkt. Es können auch andere Ausführungsformen der Detektorschaltung zweckmäßig sein, so lange die wesentliche Funktion, nämlich das Erkennen eines transienten abzuleitenden Pulses auf der Spannung führenden Leitung LV und das Erzeugen von Steuersignalen für die Durchsteuerung der aktiven Elemente bzw. Halbleiterübergänge der Schutzschaltung, im Ausführungsbeispiel der Transistoren des Thyristors SCR, funktional erfüllt werden.

Maßgebend ist, dass das transiente Signal einerseits erkannt wird und andererseits im Normalbetrieb der Thyristor SCR nicht gezündet wird. Die Zeitkonstante des RC-Gliedes bestimmt einerseits das Erkennen eines transienten Pulses als auch andererseits die Zeit, während der die Detektorschaltung aktiv ist. Ein Puls wird erkannt und detektiert, so lange die Anstiegszeit der transienten Störung kleiner ist als die Zeitkonstante des RC-Gliedes. Andererseits bestimmt die Zeitkonstante nach Abklingen des Pulses die Zeit, nach der die Detektorschaltung inaktiv wird und abschaltet bzw. wieder in den Normalbetrieb zurückkehrt.

Dazu wird in den Bespielen der Figur 1 das RC-Glied mit seiner Zeitkonstante so eingestellt, dass diese Bedingungen erfüllt werden. Da in diesen Ausführungsbeispielen der Thyristor im Fehlerfall nur gezündet wird, nicht jedoch abgeschaltet werden muss, genügt es, die ansteigende Flanke eines transienten Pulses zu erkennen.

Bei jeweils einer kleinen Kapazität des RC-Gliedes, beispielsweise realisiert als Gateoxidkapazität, wird der Widerstand dieser Kapazität bei transienten Vorgängen niedrig, so dass im Beispiel der Figur 1b) der Ausgang des RC-Gliedes sehr schnell auf hohes Potential gebracht wird, während der Ausgang der Detektorschaltung in der Figur 1c) sehr schnell auf niedriges Potential gebracht wird. Bei kleinen Spannungsänderungen und bei Gleichspannung wirken die Widerstände der Kapazitäten des RC-Gliedes in beiden Beispielen als hochohmige Bauelemente, so dass in der Figur 1b) der Ausgang der Detektorschaltung auf niedrigem Potential gehalten wird, während er in der Schaltung nach Figur 1c) auf hohem Potential gehalten wird.

Die Schaltungsanordnungen der Figur 2 zeigen ein zweites Beispiel. Im Unterschied zu den in Figur 1 gezeigten Beispielen ist in den Schaltungsanordnungen der Figur 2 ein zusätzlicher Schaltkreis vorgesehen, der bestimmt, wie lange die Steuerschaltung aktiv bleibt. Damit kann gewährleistet werden, dass die Steuersignale der Steuerschaltung den Thyristor SCR zumindest so lange durchsteuern, bis der transiente Puls auf der Leitung LV oder dem Anschluss PV mit Sicherheit abgeklungen ist.

Im Vergleich des Beispiels nach Figur 2a) mit dem Beispiel der Figur 1b) besteht der Unterschied darin, dass zwischen das erste RC-Glied aus den Elementen C12 und R12, das den transienten Puls auf der Spannung führenden Leitung LV oder dem Anschluss PV detektiert und die Steuerschaltung aktiviert, und den Invertern für die Ansteuerung des Thyristors SCR eine Zusatzschaltung angeordnet ist. Dabei entsprechen zunächst die Inverter I1, I2 und I3 nach dem Beispiel der Figur 1b) in dieser Reihenfolge in der Figur 2a) den Invertern I20, 130 und I40. Die Funktion dieser Inverter in der Figur 2a) ist identisch wie bei den Invertern des ersten Beispiels, jedoch kann die Dimensionierung und die Realisierung der Inverter auf verschiedene Weise ausgeführt sein.

Dem Ausgang des ersten RC-Gliedes aus R12 und C12 ist als Element der Zusatzschaltung ein Inverter I10 nachgeschaltet, der einen PMOS-Transistor P10 ansteuert. Ausgangsseitig ist dieser Transistor einerseits mit der Spannung führenden Leitung LV und andererseits mit den Eingängen der Inverter I20 und I30 verbunden. An dem letzteren Verbindungspunkt ist weiterhin die Parallelschaltung eines zweiten RC-Gliedes aus der Kapazität C21 und dem Widerstand R21 angeschlossen, die mit ihrem anderen Anschluss jeweils an dem Bezugspotential VB bzw. der Leitung LB angeschlossen sind.

Bei einer transienten Störung auf der Leitung LV oder dem Anschluss PV wird diese durch das erste RC-Glied erkannt. Der Ausgang dieses ersten RC-Gliedes, das den Inverter I10 ansteuert, nimmt bei einem schnellen Pulsanstieg durch die dann niederohmige Kapazität C12 hohes Potential an, sodass der Inverter I10 ausgangsseitig auf niedriges Potential gebracht wird. Wie in den Beispielen der Figur 1 muss die Anstiegszeit der transienten Störung auf der Leitung LV dabei kürzer sein als die Zeitkonstante des ersten RC-Gliedes.

Mit dem dann niederohmigen Ausgang des Inverters I10 wird der PMOS-Transistor P10 durchgesteuert, dessen Ausgang die Invertereingänge der Inverter 120 und I30 auf hohes Potential legt. Wie schon anhand des Beispiels der Figur 1b) erläutert, werden nachfolgend die Transistoren T1 und T2 durchgesteuert, so dass der Thyrister SCR leitend wird und den Puls auf der Leitung LV gegen Bezugspotential abführen kann.

Die Zeitkonstante des zweiten RC-Gliedes aus den Elementen C21 und R21 kann unabhängig von der Zeitkonstante des ersten RC-Gliedes eingestellt werden und bestimmt in dieser Situation, wie lange die Steuerschaltung aktiv bleibt und Steuersignale an die Transistoren T1 und T2 erzeugt. Solange P10 durchgeschaltet bleibt, sind die Inverter I20, I30 und I40 in der Lage, die Steuerströme für die Durchschaltung der Transistoren T1 und T2 zu erzeugen. Sobald P10 abschaltet, z.B. weil sich der transiente Puls verflacht und die Zeitkonstante des ersten RC-Gliedes kürzer als die Spannungsänderungen auf der Leitung LV werden, wird der Verbindungsknoten der Eingänge der Inverter I20 und I30 mit dem zweiten RC-Glied über dieses RC-Glied und dessen Zeitkonstante gegen Bezugspotential entladen. Typischerweise wird die Zeitkonstante des zweiten RC-Gliedes so eingestellt, dass die Steuerschaltung die Steuersignale an den Thyristor so lange abgibt, wie die transiente Störung andauert. Das bedeutet, dass die Zeitkonstante des zweiten RC-Gliedes größer ist als die Zeitkonstante des ersten RC-Gliedes. Auf diese Weise können mittels des ersten und des zweiten RC-Gliedes unterschiedliche transiente Pulsformen erfasst und abgeleitet werden. Weiterhin können die Zeitkonstanten der beiden RC-Glieder unabhängig voneinander im Hinblick auf ihre Funktion optimiert werden.

Figur 2b) unterscheidet sich vom Beispiel der Figur 2a dadurch, dass die Inverter konkret als CMOS-Inverter I11, I21, I31 und I41 ausgeführt sind.

Selbstverständlich kann das Ausführungsbeispiel mit einem zweiten RC-Glied auch an das erste Ausführungsbeispiel nach Figur 1c angepasst werden.

Die vorstehend beschriebenen aktiv getriggerten Schutzschaltungskonzepte machen von Invertern Gebrauch. Die Inverter liefern die Spannungen bzw. Ströme mit den notwendigen kurzen Signalanstiegszeiten, um die eigentliche Schutzschaltung zu triggern.

Der Einsatz von Invertern in Hochvoltanwendungen ist wiederum nicht völlig unproblematisch. Hochvoltbauelemente, die unter Verwendung von Hochvoltprozessen hergestellt sind, weisen oft unsymmetrische Betriebsparameter bzw. Betriebsbedingungen auf, die in der Natur des Hochvoltprozesses, insbesondere den mehrfachen Isolationswannen, begründet sind. Zum Beispiel kann die maximal zulässige Drain-Source-Spannung eines MOS-Transistors beträchtlich höher sein als die entsprechende maximal zulässige Gate-Bulk-Spannung. Deshalb können bestimmte Bauelement-Konfigurationen, wie z.B. Standard-Inverter, nicht für die möglichen Spannungsbereiche hergestellt werden.

Gemäß dem ersten Ausführungsbeispiel der Erfindung ist die Steuerschaltung in Figur 3 durch eine Detektorschaltung mit nachgeschalteten Steuertransistoren TH1 und TL1 als Ausgangs-Schaltelementen realisiert. Die Detektorschaltung enthält zwei Teilschaltungen, von denen eine den Transistor T1 und die andere den Transistor T2 ansteuert. Grundsätzlich enthält auch in diesem Fall jede Detektorteilschaltung zur Transientenerkennung ein RC-Glied aus der Serienschaltung einer Kapazität und eines Widerstands, das mit den Leitungen LV bzw. LB und den entsprechenden Anschlüssen PV und PB verbunden ist.

Jede Detektorteilschaltung aus Kapazität und Widerstand bildet als RC-Glied einen komplexen Spannungsteiler, an dessen Mittelabgriff der Spannungsanstieg des Störpulses erfasst wird. Im Fehlerfall eines transienten Pulses wird, wie beschrieben, der (komplexe) Widerstand der Kapazität niedrig ("niederohmig"), so dass sich am Ausgangsknoten der Detektorschaltung je nach Polung der RC-Schaltung ein niedriges bzw. hohes Potential einstellt. Sobald die Knotenspannung die Schaltschwelle des Detektortransistors (TD1 bzw. TD2) erreicht, schaltet dieser durch und erzeugt an seinem Ausgang ein Potential, das die Steuertransistoren (TH1 bzw. TL1) ansteuern und durchschalten kann. Die Ausgangsspannungen der geschalteten Steuertransistoren bewirken, dass der pn-Übergang zwischen Emitter und Basis von T1 bzw. T2 die Schaltschwelle überschreitet und die Schutzschaltung durchschaltet.

Die Detektorteilschaltung für die Ansteuerung von T1 ist aus der Serienschaltung einer Kapazität C13 und eines Widerstands R13 ausgeführt. Dem Verbindungsknoten der Kapazität C13 und des Widerstandes R13 ist der Transistor TD1 nachgeschaltet. TD1 ist als p-Kanal-Transistor ausgebildet. TD1 steuert ausgangsseitig den n-Kanal-Steuertransistor TL1 an. TL1 ist ausgangsseitig mit der Basis von T1 verbunden.

Im Fall einer transienten Störung wird der Widerstand von C13 niedrig, so dass TD1 durchschaltet und der Ausgang von TD1 hohes Potential, insbesondere VV, annimmt und TL1 durchsteuert. Der Ausgang von TL1 bzw. die Basis von T1 werden dadurch auf Bezugspotential VB gelegt und T1 schaltet durch.

Die Detektorteilschaltung für die Ansteuerung von T2 unterscheidet sich von der Detektorteilschaltung für die Ansteuerung von T1 dadurch, dass die RC-Serienschaltung aus dem kapazitiven und dem resistiven Bauelement in umgedrehter Richtung mit den Anschlüssen PV und PB verbunden ist. Dabei liegt der Widerstand R2 am Anschluss PB und die Kapazität C2 am Anschluss PV. Somit drehen sich die Spannungsverhältnisse am Ausgang der Detektorschaltung, nämlich dem Verbindungspunkt von R2 und C2 um, sodass auch die Ansteuerung des Transistors T2 anders erfolgen muss.

Dem Verbindungsknoten der Kapazität C2 und des Widerstandes R2 ist der Transistor TD2 nachgeschaltet. TD ist als n-Kanal-Transistor ausgebildet. TD2 steuert ausgangsseitig den p-Kanal-Steuertransistor TH1 an. TH1 ist ausgangsseitig mit der Basis von T2 verbunden.

Im Fall einer transienten Störung wird der Widerstand von C2 niedrig, so dass TD2 schaltet und der Ausgang von TD2 niedriges Potential, insbesondere VB, annimmt und TH1 durchsteuern kann. Der Ausgang von TH1 bzw. die Basis von T2 werden dadurch auf hohes Potential VV gelegt und T2 schaltet durch.

Es können auch andere Ausführungsformen der Detektorschaltung zweckmäßig sein, so lange die wesentliche vorstehend beschrieben Funktion erfüllt wird.

Maßgebend ist, dass das transiente Signal einerseits erkannt wird und andererseits im Normalbetrieb der Thyristor SCR nicht gezündet wird. Die Zeitkonstante des RC-Gliedes bestimmt das Erkennen eines transienten Pulses.

Dann schaltet T2 zeitgleich oder nahezu zeitgleich mit T1 in den leitenden Zustand über. Damit wird der Thyristor SCR leitend und der auf der Leitung LV bzw. dem Anschluss PV anliegende transiente Puls kann gegen Bezugspotential abgeleitet werden. Selbstverständlich kann man auch unterschiedliche Zeitkonstanten einstellen, wenn sich diese Notwendigkeit ergeben sollte.

Die in Figur 3 dargestellten Elemente R3, C3 und R4, C4 bestimmen, wie lange die Steuerschaltung aktiv bleibt bzw. nach welcher Zeit die Schutzschaltung SCR wieder abgeschaltet wird. Damit kann gewährleistet werden, dass die Steuersignale der Steuerschaltung den Thyristor SCR zumindest so lange durchsteuern, bis der transiente Puls auf der Leitung LV oder dem Anschluss PV mit Sicherheit abgeklungen ist.

So ist zwischen dem Basisanschluss des Transistors TL1 und Bezugpotential VB die Parallelschaltung eines weiteren RC-Gliedes aus der Kapazität C3 und dem Widerstand R3 angeschlossen. Zwischen dem Basisanschluss des Transistors TH1 und hohem Potential VV ist die Parallelschaltung eines RC-Gliedes aus der Kapazität C4 und dem Widerstand R4 angeschlossen.

Die Zeitkonstanten des RC-Gliedes aus den Elementen C3, R3 bzw. C4, R4 können unabhängig von der zugeordneten Zeitkonstante des RC-Gliedes aus C13, R13 bzw. C2, R2 eingestellt werden und bestimmen, wie lange die Steuerschaltung aktiv bleibt und die Steuersignale an den Transistoren T1 und T2 anliegen. Solange TL1 bzw. TH1 durchgeschaltet bleiben, können TL1 bzw. TH1 die Steuerströme für die Durchschaltung der Transistoren T1 und T2 erzeugen.

Sobald sich der transiente Puls verflacht und die Zeitkonstante der RC-Glieder aus C13, R13 bzw. C2, R2 kürzer als die Spannungsänderungen auf der Leitung LV werden, werden die Eingänge von TD1 bzw. TD2 über diese RC-Glieder und ihre Zeitkonstanten gegen hohes Potential bzw. Bezugspotential gelegt. TD1 und TD2 schalten ab.

Typischerweise werden die Zeitkonstanten R3, C3 und R4, C4 so eingestellt, dass die Steuerschaltung die Steuersignale an die Schutzschaltung so lange abgibt, wie die transiente Störung andauert. Nach Maßgabe der Zeitkonstanten von C3 und R3 bzw. C4 und R4 werden bei abgeschalteten Transistoren TD1 bzw. TD2 die Eingänge der Steuertransistoren TL1 bzw. TH1 gesperrt und die Steuerströme von T1 und T2 werden abgeschaltet.

Über die Einstellung der Zeitkonstanten können unterschiedliche transiente Pulsformen erfasst und abgeleitet werden. Weiterhin können die Zeitkonstanten der RC-Glieder unabhängig voneinander im Hinblick auf ihre Funktion optimiert werden.

Figur 4 zeigt ein weiteres Ausführungsbeispiel der Erfindung, das sich gegenüber dem Ausführungsbeispiel der Figur 3 im Wesentlichen dadurch unterscheidet, dass zusätzliche Gatetreiber-Transistoren eingesetzt werden. Damit wird eine Verbesserung des Schaltverhaltens der Steuer- bzw. Triggertransistoren TH10 und TL10 möglich.

Durch den Einsatz der Gatetreiber-Transistoren ist gegenüber Figur 1 eine Anpassung der Elemente der Steuerschaltung an die Polarität der Steuersignale erforderlich. Der Einsatz von Transistor T11 als Gatetreiber für TD10 erfordert eine Umpolung des detektierenden RC-Gliedes, so dass C10 mit VV und R10 mit VB verbunden ist. Der n-Kanal-Treibertransistor T12 im Ausgangskreis von TD10 steuert den p-Kanal-Schalttransistor TH10 an und dieser wiederum T20. Entsprechendes gilt für die zweite Detektorteilschaltung für R20, C20 und den Treibertransistor T21, die den Detektoreingangskreis für den Detektortransistor TD20 bilden. Der p-Kanal-Treibertransistor T13 im Ausgangskreis von TD20 steuert den n-Kanal-Schalttransistor TL10 an und dieser wiederum T10. Für die Auslegung der RC-Glieder gelten die Ausführungen zu Figur 1 entsprechend.

Die Ausführungsbeispiele der Figuren 3 und 4 ist die Steuerschaltung zur Detektion des transienten Ereignisses und zur Ansteuerung von T1 bzw. T2 aus zwei Teilkreisen bzw. Teilschaltungen aufgebaut, die jedem der Transistoren T1 bzw. T2 separat zugeordnet sind. Die getrennte Ausführung der Teilschaltungen der Steuerschaltung ermöglicht eine unabhängige Dimensionierung und Optimierung dieser Teilschaltkreise.

Das weitere Ausführungsbeispiel gemäß Figur 5 unterscheidet sich von dem Ausführungsbeispiel der Figur 4 dadurch, dass beide Steuertransistoren TL10 bzw. TH10 mit vorgeschalteten Treibertransistoren T13 bzw. T12 dieselbe Detektorschaltung verwenden. T12 dient dabei nicht nur zur Ansteuerung von TH10, sondern auch zur Ansteuerung des Gatetreiber-Transistors T13 und des nachgeschalteten Schaltelements TL10. Die Elemente C10, R10, T11, TD10 sowie C30, R30 sind nur einmal in der Schutzschaltung vorgesehen.Somit können die Elemente R20, C20, R40, C40, TD20 und T21 der zweiten Detektorteilschaltung entfallen.

Bei dem Ausführungsbeispiel gemäß Figur 5 entfällt zwar eine unabhängige Dimensionierung der Detektorteilkreise, weil der Detektorkreis nur einmal vorhanden ist. Eine unabhängige Dimensionierung der Detektorteilschaltungen ist aber in vielen Fällen nicht erwünscht oder nicht notwendig, wenn gleiche Zeitkonstanten für die Ansteuerung von T10 bzw. T20 gewünscht sind. Andererseits ermöglicht die Schaltung die signifikante Reduzierung und die Optimierung des Flächenbedarfs der Schutzschaltung auf dem Halbleiterchip. Nach wie vor ist jedoch eine unabhängige Dimensionierung und Optimierung der Steuertransistoren TH10 bzw. TL10 und ihrer Treibertransistoren T12 bzw. T13 möglich.

Gemäß dieser Ausführungsform der Erfindung werden durch den Einsatz von Einzeltransistoren in der Steuerschaltung keine Inverter benötigt, um die Schutzschaltung SCR zu triggern. Eine Optimierung der Einzeltransistoren, die als Schaltelemente der Steuerschaltung eingesetzt werden, ist bei jedem Herstellprozess der integrierten Schaltung, insbesondere bei Hochvoltprozessen, aber auch bei Standardprozessen, möglich. Somit kann auch unter Verwendung eines Hochvoltprozesses wie auch bei Niedervoltprozessen eine optimierte Schutzschaltung hergestellt werden.

Selbstverständlich ist die Erfindung nicht auf die Verwendung von MOS-Transistoren als Schaltelemente beschränkt. Ebenso können bipolare Transistoren als Schaltelemente eingesetzt werden.

Die Struktur der Schutzanordnung im Halbleiterbauelement gibt das Ausführungsbeispiel gemäß Figur 6 an. In dem nicht näher dargestellten Halbleiter ist eine niedrig p-dotierte Wanne 10 angeordnet. Die Wanne 10 kann auch das Substrat des Halbleiters sein. In der Wanne 10 ist eine n-dotierte Wanne 20 angeordnet. Der Thyristor aus T1 und T2 ist im Ausführungsbeispiel unter Verwendung eines Hochvoltprozesses in die n-Wanne 20 eingebettet. Die n-Wanne 20 dient dabei zur Beherrschung der hohen auftretenden Spannungen.

In der Wanne 20 sind hochdotierte Bereiche mit p- bzw. n-Leitfähigkeit angeordnet, die in üblicher Weise beispielsweise durch Implantation oder Diffusion erzeugt werden können. Der hochdotierte n-Bereich 21 sowie der hochdotierte p-Bereich 22 können separat an ein Potential gelegt werden, jedoch müssen sie im Betrieb das gleiche Potential aufweisen. Dazu sind sie jeweils mit dem hohen Potential VV verbunden. Der hochdotierte n-Bereich 23 ist mit dem Ausgang CTL der Steuerschaltung verbunden.

Ebenfalls in der n-Wanne 20 ist eine p-dotierte Wanne 30 angeordnet. In dieser Wanne 30 sind zwei hochdotierte p-Bereiche 31 und 33 sowie ein hochdotierter n-Bereich 32 angeordnet. Diese können in ähnlicher Weise wie die hochdotierten Bereiche der n-Wanne durch Implantation oder Diffusion in herkömmlicher Weise hergestellt sein. Die Bereiche 32 und 33 können separat an ein Potential gelegt werden, jedoch müssen sie im Betrieb das gleiche Potential aufweisen. Dazu sind sie im Beispiel jeweils mit dem Bezugspotential VB verbunden. Der Bereich 31 ist mit dem Ausgang CTH der Steuerschaltung verbunden.

Oberhalb der Grenzbereiche der n-Wanne 20 und der p-Wanne 30 sind Feldplatten P11 und P12 aus Polysilizium (typischerweise als Polyl-Schicht) ausgebildet. Die Feldplatten dienen zur Steuerung des elektrischen Feldes bei den hohen Betriebsspannungen und erhöhen die Durchbruchspannung der Anordnung. Dadurch ergibt sich eine geringere Anfälligkeit der Schaltung gegen eine falsche Triggerung.

Die parasitäre Thyristorstruktur mit den Transistoren T1 und T2 ist in die n- bzw. p-Wanne eingezeichnet. Danach ergibt sich der Kollektor des npn-Transistors T2 zwischen dem Bereich 21 mit nachgeschaltetem Widerstand RN der n-Wanne 20 und dem Bereich 23. Die Basis ergibt sich aus dem Bereich 31 sowie dem Kollektor von T1 und ist über den Widerstand RP der p-Wanne 30 mit Bezugspotential VB verbunden. Die Basis dieses Transistors T2 ist mit dem Bereich 31 als Steueranschluss verbunden, an den das Steuersignal CTH zum Ein- und Ausschalten des Transistors angelegt werden kann. Der Emitter ergibt sich als Bereich 32.

Die Basis des pnp-Transistors T1 ergibt sich zwischen dem Bereich 21 und dem nachgeschalteten Bahnwiderstand RN der n-Wanne 20 sowie dem Kollektor des Transistors T2 bzw. dem Bereich 23, an dem das Signal CTL anliegt. Der Kollektor von T1 ergibt sich zwischen Anschluss 33 mit nachgeschaltetem Bahnwiderstand RP der p-Wanne 30 und dem Bereich 31. Der Emitter des Transistors T1 ist mit dem Bereich 22 verbunden. Das Steuersignal CTL dient zum Ein- bzw. Ausschalten des Transistors T1.

Die Steuerleitungen bzw. Steuersignale CTL bzw. CTH werden zunächst auf niedriges Potential (Bereich 23) bzw. hohes Potential (Bereich 31) gelegt, um die Transistoren T1 und T2 einzuschalten. Dabei wird jeweils ein Basisstrom für den pnp- bzw. npn-Transistor bereitgestellt. Die Basisströme schalten den jeweiligen Transistor ein und zünden somit den Thyristor. Damit ist die Schutzfunktion zwischen den Leitungen LV und LB in Betrieb.

Zum Ausschalten des Thyristors wird der Bereich 23 über den Anschluss CTL nach Abschalten des Steuertransistors TL1 mittels des Bahnwiderstands RN an hohes Potential gelegt und der Bereich 31 über den Anschluss CTH nach Abschalten des Steuertransistors TH1 mittels des Bahnwiderstands RP an niedriges Potential. Damit sperren die Transistoren T1 und T2 und damit den Thyristor.

## Patentansprüche

1. Schaltungsanordnung zum Schutz einer integrierten Halbleiherschaltung mit
- einer Schutzschaltung (PC; SCR), die eine Thyristorstruktur (T1, T2; T10, T20) mit zwei aktiven Elementen enthält und zwischen ein zu schützendes Element (VV) und ein Bezugspotential (VB) geschaltet ist, und mit
- einer Steuerschaltung (TC; R2, C2, TD2, TH1, R13, C13, TD1, TL1) die zur Ansteuerung der Schutzschaltung eingerichtet ist und parallel zu der Schutzschaltung zwischen das zu schützendes Element und das Bezugspotential (VB) geschaltet ist, wobei
- die Steuerschaltung eine Detektorschaltung (R2, C2, TD2, R13, C13, TD1) und zwei als Einzeltransistoren ausgebildete Schaltelemente (TH1, TL1) enthält, die jeweils an ihrem Steuereingang mit der Detektorschaltung verbunden sind und an ihrem Ausgang Steuersignale (CTH, CTL) erzeugen und jeweils ein aktives Element (T1, T2) der Schutzschaltung (SCR) ansteuern,
- die Ausgangsanschlüsse des einen Schaltelements (TH1) mit dem einen der zwei aktiven Elemente (T2) der Schutzschaltung einerseits und mit dem zu schützenden Element andererseits verbunden sind,
- die Ausgangsanschlüsse des anderen Schaltelements (TL1) mit dem anderen der zwei aktiven Elemente (T1) der Schutzschaltung einerseits und mit dem Bezugspotential (VB) andererseits verbunden sind
- eine erste und eine zweite Parallelschaltung eines RC-Gliedes zur Steuerung eines Ausschaltvorgangs, von denen die erste Parallelschaltung zwischen dem Steuereingang des einen Schaltelement (TH1) und dem zu schützenden Element und die zweite Parallelschaltung zwischen dem Steuereingang des anderen Schaltelement (TL1) und dem Bezugspotential (VB) angeordnet ist.

2. Schaltungsanordnung nach Anspruch 1, bei der die Einzeltransistoren der Schaltelemente von unterschiedlichem Leitfähigkeitstyp sind und die Schutzschaltung gegenpolig ansteuern.

3. Schaltungsanordnung nach Anspruch 1 oder 2, bei der den zwei Schaltelementen (TH10, TL10) jeweils ein Treiberelement (T12, T13) vorgeschaltet ist.

4. Schaltungsanordnung nach Anspruch 1 bis 3, bei der die Detektorschaltung mindestens ein Detektorschaltelement (TD10; TD20) enthält.

5. Schaltungsanordnung nach Anspruch 1 bis 4, bei der die Schaltelemente als MOS- oder Bipolartransistoren (TH1, TL1; TH10, TL10) ausgebildet sind.

6. Schaltungsanordnung nach Anspruch 1 bis 5, bei der die Detektorschaltung ein erstes RC-Glied (R2, C2; R13, C13) aus einem Widerstand und einer Kapazität enthält und zum Erkennen eines Signalanstiegs mit vorgegebener Anstiegszeit an dem zu schützenden Element (PV, LV) ausgelegt ist.

7. Schaltungsanordnung nach einem der Patentansprüche 1 bis 6, bei der die Detektorschaltung aus zwei Detektorteilschaltungen ausgebildet ist, die jeweils eines der zwei Schaltelemente (TH1, TL1) ansteuern.

8. Schaltungsanordnung nach einem der Ansprüche 1 bis 7, bei der die Steuereingänge der aktiven Elemente der Schutzschaltung in einer Halbleiterstruktur mittels Wannen unterschiedlichen Leitfähigkeitstyps ausgeführt sind, in denen hochdotierte Bereiche für die Ausgangskreise der aktiven Elemente (T1, T2) angeordnet sind.

## Claims

1. A circuit arrangement for protecting an integrated semiconductor circuit comprising
- a protection circuit (PC; SCR) which comprises a thyristor structure (T1, T2; T10, T20) with two active elements and is connected between an element to be protected (VV) and a reference potential (VB), and
- a control circuit (TC; R2, C2, TD2, TH1, R13, C13, TD1, TL1) which is designed to drive the protection circuit and is connected in parallel with the protection circuit between the element to be protected and the reference potential (VB), wherein
- the control circuit comprises a detector circuit (R2, C2, TD2, R13, C13, TD1) and two switching elements (TH1, TL1) designed as individual transistors, each of the switching elements being connected to the detector circuit at its control input and generating control signals (CTH, CTL) at its output, and each driving an active element (T1, T2) of the protection circuit (SCR),
- the output connections of one switching element (TH1) are connected to one of the two active elements (T2) of the protection circuit on the one hand and to the element to be protected on the other hand,
- the ouput connections of the other switching element (TL1) are connected to the other active element (T1) of the protection circuit on the one hand and to the reference potential (VB) on the other hand
- a first and a second parallel circuit of an RC element for controlling a switching-off process, the first parallel circuit being arranged between the control input of one switching element (TH1) and the element to be protected and the second parallel circuit being arranged between the control input of the other switching element (TL1) and the reference potential (VB).

2. The circuit arrangement as claimed in claim 1, wherein the switching elements comprise individual transistors of different conductivity types and drive the protection circuit in an antipolar manner.

3. The circuit arrangement as claimed in claim 1 or 2, wherein a driver element (T12, T13) is connected upstream of each of the two switching elements (TH10, TL10).

4. The circuit arrangement as claimed in claims 1 to 3, wherein the detector circuit comprises at least one detector switching element (TD10; TD20).

5. The circuit arrangement as claimed in claims 1 to 4, wherein the switching elements are in the form of MOS or bipolar transistors (TH1, TL1; TH10, TL10).

6. The circuit arrangement as claimed in claims 1 to 5, wherein the detector circuit comprises a first RC element (R2, C2; R13, C13) comprising a resistor and a capacitance and is configured to identify a signal rise with a predetermined rise time at the element to be protected (PV, LV).

7. The circuit arrangement as claimed in one of claims 1 to 6, wherein the detector circuit comprises two detector subcircuits, each of which drives one of the two switching elements (TH1, TL1).

8. The circuit arrangement as claimed in one of claims 1 to 7, wherein the control inputs of the active elements of the protection circuit are formed in a semiconductor structure by means of wells of different conductivity, with highly doped regions for the output circuits of the active elements (T1, T2) being arranged in said wells.

## Revendications

1. Montage de circuits destiné à protéger un circuit intégré à semiconducteur, comportant
- un circuit de protection (PC ; SCR) qui contient une structure de thyristor (T1, T2 ; T10, T20) comprenant deux éléments actifs et qui est monté entre un élément à protéger (VV) et un potentiel de référence (VB), et comportant
- un circuit de commande (TC ; R2, C2, TD2, TH1, R13, C13, TD1, TL1) qui est configuré pour commander le circuit de protection et qui est monté en parallèle au circuit de protection entre l'élément à protéger et le potentiel de référence (VB),
- le circuit de commande contenant un circuit de détection (R2, C2, TD2, R13, C13, TD1) et deux éléments de commutation (TH1, TL1) configurés comme transistors individuels, lesquels sont chacun reliés au circuit de détection sur leur entrée de commande et génèrent des signaux de commande (CTH, CTL) sur leur sortie et commandent chacun un élément actif (T1, T2) du circuit de protection (SCR),
- les bornes de sortie de l'un des éléments de commutation (TH1) étant reliées à l'un des deux éléments actifs (T2) du circuit de protection d'un côté et à l'élément à protéger de l'autre,
- les bornes de sortie de l'autre élément de commutation (TL1) étant reliées à l'autre des deux éléments actifs (T1) du circuit de protection d'un côté et au potentiel de référence (VB) de l'autre,
- un premier et un deuxième circuit parallèle d'un circuit RC servant à commander une opération de déconnexion, dont le premier circuit parallèle est disposé entre l'entrée de commande d'un élément de commutation (TH1) et l'élément à protéger et le deuxième circuit parallèle entre l'entrée de commande de l'autre élément de commutation (TL1) et le potentiel de référence (VB).

2. Montage de circuits selon la revendication 1, où les transistors individuels des éléments de commutation sont de type de conductibilité différent et commandent le circuit de protection de façon antipolaire.

3. Montage de circuits selon la revendication 1 ou 2, où un élément pilote (T12, T13) est monté en aval de chacun des deux éléments de commutation (TH10, TL10).

4. Montage de circuits selon l'une des revendications 1 à 3, où le circuit de détection contient au moins un élément de commutation de détection (TD10 ; TD20).

5. Montage de circuits selon l'une des revendications 1 à 4, où les éléments de commutation sont configurés comme transistors MOS ou bipolaires (TH1, TL1 ; TH10, TL10).

6. Montage de circuits selon l'une des revendications 1 à 5, où le circuit de détection contient un premier circuit RC (R2, C2 ; R13, C13) constitué d'une résistance et d'une capacité et est conçu pour détecter une montée de signal avec un temps de montée prédéfini au niveau de l'élément à protéger (PV, LV).

7. Montage de circuits selon l'une des revendications 1 à 6, où le circuit de détection est constitué de deux circuits de détection partiels qui commandent chacun l'un des deux éléments de commutation (TH1, TL1).

8. Montage de circuits selon l'une des revendications 1 à 7, où les entrées de commande des éléments actifs du circuit de protection sont réalisées dans une structure de semiconducteur moyennant des cuves de type de conductibilité différent, dans lesquelles sont disposées des zones fortement dopées pour les circuits de sortie des éléments actifs (T1, T2).
